# EUROPEAN PATENT APPLICATION

(11) **EP 4 645 380 A1**
(43) Date of publication of application: **05.11.2025**
(21) Application number: 25171772.4
(22) Date of filing: 22.04.2025
(51) Int. Cl.: H01L 21/768, H01L 23/532

(54) **SELECTIVE CAP DEPOSITION ON GRAPHENE-CAPPED CONDUCTIVE LINES**

(30) Priority: 02.05.2024 US 202418653195
(71) Applicant: Intel Corporation, Santa Clara, CA 95054 (US)
(72) Inventor: ESAN, Dominic, Hillsboro, 97123 (US); KUMAR, Kitty, Vancouver, 98684 (US); SIMS, Patrick, Beaverton, 97006 (US); DASSANAYAKE, Arosha, Beaverton, 97007 (US); WALKER, Bryce, Canby, 97013 (US); GHADGE, Shrinath, Hillsboro, 97124 (US); SU, Qing, Portland, 97229 (US); AL-KUKHUN, Ahmad, Beaverton, 97007 (US)
(74) Representative: 2SPL Patentanwälte PartG mbB

(57) **Abstract**

Disclosed herein are integrated circuit (IC) structures fabricated with selective cap deposition techniques on graphene-capped conductive lines and IC structures and devices with graphene on capped conductive lines. In one example, an IC structure includes an interconnect layer with a conductive line, a conductive cap layer over the conductive line, and a layer of graphene between the conductive line and the conductive cap or a layer of graphene over the conductive cap. In one such example, the layer of graphene may enable lower resistance in the conductive line and the conductive cap may improve electromigration reliability.

## Description

### Background

For the past several decades, the scaling of features in integrated circuits (ICs) has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component is becoming increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a cross-sectional side view of an example IC structure fabricated with selective cap deposition on graphene-capped conductive lines, in accordance with some embodiments.
FIGS. 2A-2B illustrate an example IC structure with an interconnect layer including a conductive cap and a layer of graphene over a conductive line, in accordance with some embodiments.
FIGS. 3A-3B illustrate another example IC structure with an interconnect layer including a conductive cap and a layer of graphene over a conductive line, in accordance with some embodiments.
FIG. 4 illustrates an example IC structure with a metallization stack including multiple interconnect layers that include a conductive cap and a layer of graphene over the conductive lines, in accordance with some embodiments.
FIG. 5 is a flow diagram of an example method for fabricating an IC structure using selective cap deposition on graphene-capped conductive lines, in accordance with some embodiments.
FIGS. 6A-6D provide cross-sectional side views at various stages in the fabrication of an example IC structure according to the method of FIG. 5, in accordance with some embodiments.
FIG. 7 is a flow diagram of an example method for fabricating an IC structure including a layer of graphene over capped conductive lines.
FIGS. 8A-8D provide cross-sectional side views at various stages in the fabrication of an example IC structure according to the method of FIG. 7, in accordance with some embodiments.
FIG. 9 is a top view of a wafer and dies that may include any of the IC devices disclosed herein, in accordance with any of the embodiments disclosed herein.
FIG. 10 is a side, cross-sectional view of an IC package that may include any of the IC devices disclosed herein, in accordance with various embodiments.
FIG. 11 is a side, cross-sectional view of an IC device assembly that may include any of the IC devices disclosed herein, in accordance with any of the embodiments disclosed herein.
FIG. 12 is a block diagram of an example electrical device that may include any of the IC devices disclosed herein, in accordance with any of the embodiments disclosed herein.

### Detailed Description

Disclosed herein are integrated circuit (IC) structures and devices fabricated with selective cap deposition techniques on graphene-capped conductive lines and IC structures and devices with graphene on capped conductive lines. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

IC fabrication usually includes two stages. The first stage of IC fabrication is typically referred to as the front end of line (FEOL). The second stage is referred to as the back end of line (BEOL). In the FEOL, individual semiconductor devices components (e.g., transistor, capacitors, resistors, etc.) can be patterned in a wafer. In the BEOL, interconnect structures such as conductive lines and conductive vias, separated as needed by an insulator material, can be formed to provide connection between individual components. The BEOL usually starts with forming the first metal layer on the wafer. The first metal layer is often called M0. Additional metal layers can be formed on top of M0, and these metal layers are often called M1, M2, and so on.

As IC structures become more compact with smaller feature sizes and higher device density, new challenges arise in the fabrication processes of such devices. For example, forming metal lines with increasingly narrow widths to accommodate tighter pitches can lead to performance issues and failure due to increased resistance and electromigration in the metal layers.

According to examples described herein, a layer of graphene over a metal line may reduce resistance (e.g., by reducing scattering at the interface between the metal line and another conductive element, such as a conductive via). However, metal lines capped with graphene may suffer from poor electromigration performance. In one example, a layer of conductive material (such as cobalt or another suitable conductive material) may be provided over the metal line (either between the metal line and the graphene or over the graphene) to reduce electromigration from the metal line into the surrounding materials. Thus, selectively depositing a conductive cap over graphene-capped metal lines or growing graphene over cobalt-capped metal lines (or metal lines capped with another conductive material) can enable increased electromigration reliability and performance (e.g., due to lower resistance in the metal lines).

IC structures as described herein, in particular IC structures fabricated with selective cap deposition on graphene-capped conductive lines and IC structures with graphene on capped conductive lines, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC structures fabricated with selective cap deposition on graphene-capped conductive lines and IC structures with graphene on capped conductive lines as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

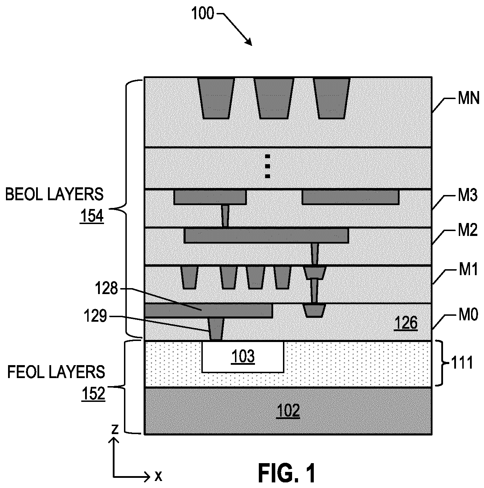

FIG. 1 is a cross-sectional side view of an example IC structure 100 that may be fabricated with selective cap deposition on graphene-capped conductive lines, in accordance with some embodiments.

The IC structure 100 includes FEOL layers 152 and BEOL layers 154. The FEOL layers 152 include a device region 111 over a substrate 102. The substrate 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. The substrate may be, include, or be a part of a support or support structure over which the FEOL layers 152 and the BEOL layers 154 are disposed.

The device region 111 may include a plurality of layers with frontend devices, such as the device 103. The device 103 may include, for example, a frontend transistor, a memory cell, or other frontend device. The device 103 may be a transistor of any architecture, such as any non-planar or planar architecture. Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field.

The BEOL layers 154 may include a plurality of backend interconnects electrically coupled to (e.g., in electrically conductive contact with at least portions of) one or more of the plurality of FEOL devices (e.g., the device 103) of the FEOL layers 152. Various BEOL interconnect layers 154 may be/include one or more metal layers of a metallization stack of the IC device. Various metal layers of the BEOL interconnect layers 154 may be used to interconnect the various inputs and outputs of the devices (e.g., logic devices) in the FEOL layer 152. The BEOL layers 154 in FIG. 1 are labeled with an M followed by a number indicating the layer in the metallization stack (e.g., metal layer 0 is M0, metal layer 1 is M1, etc.). In the example in FIG. 1, the metallization stack is depicted as having N+1 metal layers (layers M0-MN), where N is a positive integer greater than or equal to 4. However, the metallization stack may include fewer or more metal layers then depicted in FIG. 1. In one example, each of the BEOL interconnect layers 154 may include vias and lines/trenches. For example, the BEOL interconnect layer M0 includes a via portion 129 and a line or trench/interconnect portion 128. The trench portion 128 of a metal layer is configured for transferring signals and power along electrically conductive (e.g., metal) lines (also sometimes referred to as "trenches") extending in the x-y plane (e.g., in the x or y directions), while the via portion 129 of a metal layer is configured for transferring signals and power through electrically conductive vias extending in the z-direction, e.g., to any of the adjacent metal layers above or below. Accordingly, in one example, vias connect metal structures (e.g., metal lines or vias) from one metal layer to metal structures of an adjacent metal layer. While referred to as "metal" layers, various layers of the BEOL interconnect layers 154 may include only certain patterns of conductive metals, e.g., copper (Cu), aluminum (Al), tungsten (W), or cobalt (Co), or metal alloys, or more generally, patterns of an electrically conductive material, formed in an insulating medium such as an interlayer dielectric (ILD) 126. The insulating medium may include any suitable ILD materials such as silicon oxide, carbon-doped silicon oxide, silicon carbide, silicon nitride, aluminum oxide, and/or silicon oxynitride. In some embodiments, the dielectric material 126 disposed between the interconnect structures in different ones of the interconnect layers may have different compositions; in other embodiments, the composition of the dielectric material 126 between different interconnect layers may be the same.

The conductive lines in one or more interconnect layers may be formed with techniques such as a single or dual damascene process. For example, an opening, such as a trench and/or hole may be formed in an insulator material. The opening may be lined with one or more materials (e.g., a barrier layer) and then filled with a conductive fill material. In some examples, a conductive cap is formed over the conductive line. In one such example, the conductive cap may be a layer of conductive material formed over the conductive fill material. In one example, the conductive cap material may be or include cobalt and/or other suitable conductive materials, and may reduce electromigration in the conductive line.

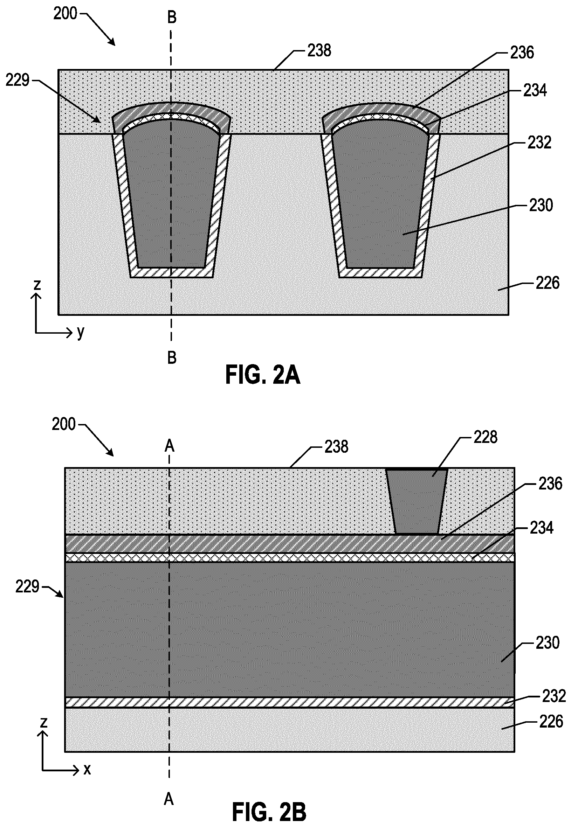

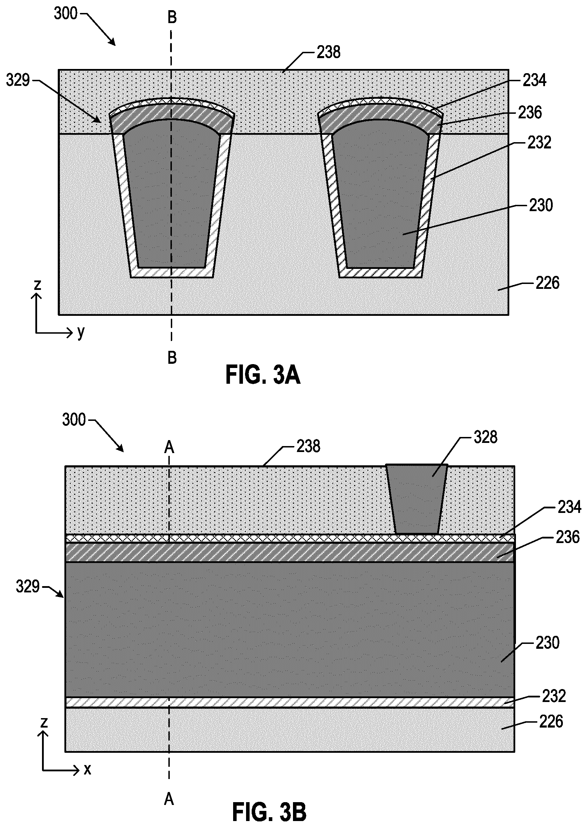

In one example, one or more of the interconnect layers may also include a layer of graphene over or under the conductive cap, which may reduce resistance (e.g., reduce resistance between the conductive line and another conductive element coupled with the conductive line). FIGS. 2A-2B and 3A-3B illustrate examples of IC structures with an interconnect layer including a conductive cap and a layer of graphene over a conductive line. FIGS. 2A-2B illustrate different cross-sectional views of the same example IC structure 200 in which a layer of graphene is between a conductive cap material and the conductive fill material of the conductive line. Specifically, FIG. 2A illustrates a cross-sectional view of the IC structure 200 along a plane AA shown in FIG. 2B, and FIG. 2B illustrates a cross-sectional view of the IC structure 200 along a plane BB shown in FIG. 2A. FIGS. 3A-3B differ from FIGS. 2A-2B in that the layer of graphene is over the conductive cap. Thus, FIGS. 3A-3B illustrate different cross-sectional views of the same example IC structure 300 in which a conductive cap material is between a layer of graphene and the conductive fill material of the conductive line. Specifically, FIG. 3A illustrates a cross-sectional view of the IC structure 300 along a plane AA shown in FIG. 3B, and FIG. 3B illustrates a cross-sectional view of the IC structure 300 along a plane BB shown in FIG. 3A. The IC structure 200 and 300 illustrate examples of interconnect layers, such as the BEOL layers 154 of FIG. 1.

Turning first to FIG. 2A, the IC structure 200 includes two conductive lines 229 (one of which is labeled) formed in openings in an insulator material 226. The insulator material 226 may be any suitable insulator material, such as the example ILDs discussed above. One or more layers may be present over the conductive lines (such as the insulator material 238), which may electrically insulate the conductive lines 229 from other conductive lines formed in the next metal layer. One or more of materials formed over the conductive lines 229 may function as etch stop layers to prevent damage to the conductive line 229 during subsequent etch processes. The conductive lines 229 include a conductive fill material 230, such as copper or another suitable conductive material.

In the example illustrated in FIGS. 2A-2B, a liner 232 is present on sidewalls and a bottom of the openings in which the conductive lines are formed. Although a single liner 232 is shown in FIGS. 2A-2B, the liner 232 may include more than one layer of material. In one such example, the liner 232 may include a material that acts as a barrier layer to prevent diffusion of the conductive fill material 230 into the surrounding insulator material 226. The liner 232 may also or alternatively include a material that acts as an adhesion layer (e.g., to improve adherence of the conductive fill material 230). In one example, the barrier layer may include one or more of: tantalum, tantalum nitride, cobalt, ruthenium, and manganese. In one such example, the barrier may include RuTaN or RuCo.

The IC structure 200 also includes a conductive layer (e.g., a conductive cap 236) over the conductive fill material 230, where the conductive cap 236 is formed from a different conductive material (e.g., has a different material composition) than the conductive fill material 230. In one example, the conductive cap 236 may be or include cobalt. The dimensions of the conductive cap 236 may vary depending on implementation. In one example, a width of the conductive cap 236 is large enough to encapsulate the conductive fill material 230 (e.g., encapsulate the conductive fill material 230 together with the liner 232. Thus, in one example, the conductive cap 236 is in contact with the liner such that there is not an intervening layer between the material of the conductive cap 236 and one or more materials of the liner 232. In one such example, the width of the conductive cap 236 is equal to about the width of the conductive line plus the width of the liner on both sides, where the width of the conductive cap 236 is a dimension of the conductive cap 236 in a plane substantially parallel to the device region (and substantially parallel to a substrate over which the device region is disposed). In one example, the thickness of the conductive cap 236 is in a range of about 1.7-4 nanometers or 1.8-2 nanometers. However, other conductive cap dimensions are possible.

The IC structure 200 also includes a layer of graphene 234 between the conductive cap 236 and the conductive fill material 230. In one example, the graphene 234 is on the conductive fill material 230 (e.g., without an intervening material between the graphene 234 and the conductive fill material 230) and the conductive cap 236 is on the graphene 234 (e.g., without an intervening material between the graphene 234 and the conductive cap 236). In one example, the layer of graphene 234 is a layer of a material that includes carbon-atoms arranged in a hexagonal lattice. In one example, the layer of graphene 234 is a monolayer of graphene having a thickness of about 10 Angstrom (e.g., in a range of about 8-12 Angstrom), where the thickness of the layer of graphene 234 is a dimension of the layer in a plane substantially orthogonal to the device region (and substantially parallel to a substrate over which the device region is disposed). Thus, in one example, the conductive cap 236 is about 1.5-3 times thicker than the layer of graphene 234 (e.g., the layer of graphene 234has a first thickness, the conductive cap 236 has a second thickness, and the second thickness is about 1.5 to 3 times greater than the first thickness). In one example, the graphene is grown on the conductive fill material 230 but not on the liner 232, and the conductive cap 236 is on both the liner 232 and the graphene 234. Thus, in one example, the width of the layer of graphene 234 is smaller than the width of the conductive cap 236.

FIG. 2B illustrates the IC structure 200 in the x-z plane, along the plane BB shown in FIG. 2A. As can be seen in FIG. 2B, a layer of graphene 234 is between the conductive fill material 230 of the conductive line 229, and a conductive cap 236 is between the insulator material 238 and the layer of graphene 234. A via 228 is coupled with the conductive line 229 and with another conductive line (not shown in FIG. 2B) in an interconnect layer above the layer shown in FIG. 2B. Thus, the layer of graphene 234 is between the conductive line 229 and the via 228.

FIGS. 3A-3B are similar to FIGS. 2A-2B in that the IC structure 300 shown in FIG. 3A includes two conductive lines 329 (one of which is labeled) formed in openings in an insulator material 226. Like the example in FIGS. 2A-2B, one or more layers may be present over the conductive lines (such as the insulator material 238), which may electrically insulate the conductive lines 329 from other conductive lines formed in the next metal layer and may function as etch stop layers. The conductive lines 329 include the conductive fill material 230 and may be lined with a liner 232, such as discussed above. The IC structure 300 differs from the IC structure 200 in that the layer of graphene 234 is over the conductive cap 236. In other words, in FIGS. 3A-3B, the conductive cap 236 is between the conductive fill material 230 and the layer of graphene 234.

FIG. 3B illustrates the IC structure 300 in the x-z plane, along the plane BB shown in FIG. 3A. As can be seen in FIG. 3B, the conductive cap 236 is between the layer of graphene 234 and the conductive fill material 230. A via 328 is coupled with the conductive line 329 and with another conductive line (not shown in FIG. 3B) in an interconnect layer above the layer shown in FIG. 3B. Thus, the layer of graphene 234 is between the conductive line 229 and the via 228, and more particularly, between the via 328 and the conductive cap 236.

Thus, FIGS. 2A-2B and 3A-2B illustrate examples of IC structures 200, 300 that include a BEOL layer/interconnect layer with a conductive line, a conductive layer (e.g., a cap) over the conductive line, an insulator layer over the conductive layer, and a layer of a material including carbon (e.g., graphene) between the conductive line and the insulator layer. The conductive cap can reduce electromigration, while the layer of graphene can improve resistance at the interface of the conductive cap with the conductive line.

As mentioned briefly above, one or multiple interconnect layers in a metallization stack may include conductive lines with both a conductive cap and a layer of graphene.

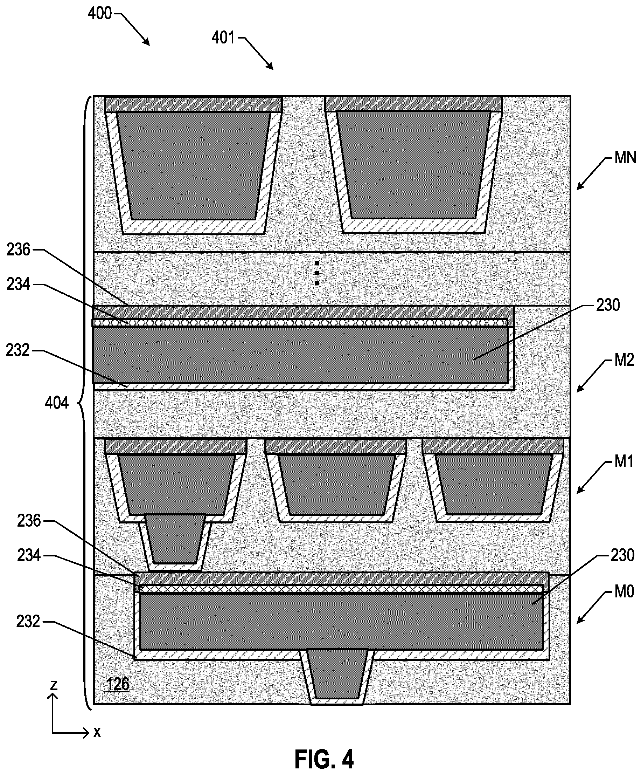

FIG. 4 illustrates a cross-sectional side view of an example IC structure with a metallization stack including multiple interconnect layers that include a conductive cap and a layer of graphene over the conductive lines.

In the example illustrated in FIG. 4, the IC structure 400 includes a metallization stack 401 with a plurality of interconnect layers 404 (which may also be referred to as metal layers), which includes N metal layers M0-MN. The ellipses (three dots) indicates that IC structure 400 may include more interconnect layers in the plurality of interconnect layers 404 than is depicted in FIG. 4. In one example, the metallization stack may further include global metal layers (e.g., layers GM0, GM1, etc.) over the local metal layers M0-MN. In one such example, global metal layers have a larger thickness and pitch relative to lower metal layers, and may include, for example, a hybrid bonding layer, a pad layer, etc., in addition to, or instead of, metal lines and vias. The interconnect layers 404 are depicted in FIG. 4 as having metal lines running in one direction (e.g., layers M0 and M2 are depicted as having metal lines extending along the x-axis, and layers M1 and MN are depicted as having metal lines extending along the y-axis, where the y-axis is going into and coming out of the page). However, an interconnect layer may include conductive interconnects along more than one axis. Also, any or all of the layers M0-MN may include conductive vias extending along the z-axis (such as shown in M1 and M2 in FIG. 4).

As mentioned above, one or multiple interconnect layers in a metallization stack may have conductive caps and graphene layers over conductive lines. In the example illustrated in FIG. 4, two of the metal layers (M0 and M2) are shown as having conductive lines with a conductive cap 236 and a layer of graphene 234 over the conductive line. As the pitch and width of conductive lines decreases, the resistance in the conductive line generally increases. Therefore, interconnect layers having metal lines with a relatively tight pitch may especially benefit from a layer of graphene over or under the conductive cap. Often the lowest metal layers have the smallest pitches in the metallization stack, and increasingly higher up metal layers have greater thicknesses relative to the previous layers. For example, in FIG. 4, the layer M0 represents the interconnect layer that is the closest to a substrate over which the interconnect layer was formed, and the layer MN is shown as the interconnect layer that is furthest from the substrate. In one such example, M0 has metal lines having a tighter pitch than other metal layers further from the substrate, such as MN. In some examples, one or more metal layers may have similar or substantially the same pitches (e.g., metal lines in M0 and M2 may have a similar pitch).

Thus, in the example illustrated in FIG. 4, the IC structure 400 includes a first interconnect layer (e.g., M0) with a conductive line including a first conductive material 230 (e.g., copper or other suitable conductive fill material), a conductive layer (e.g., a conductive cap 236) over the conductive line, where the conductive layer includes a second conductive material (e.g., cobalt or other suitable conductive cap material), an insulator layer over the conductive layer, and a layer including carbon (e.g., a layer of graphene 234) between the conductive line and the insulator layer. The IC structure may further include a second interconnect layer (e.g., M2) over the first interconnect layer, where the second interconnect layer includes a second conductive line including the first conductive material, a second conductive layer (e.g., a conductive cap 236) over the second conductive line, where the second conductive layer includes the second conductive material, a second insulator layer over the second conductive layer, and a second layer including carbon (e.g., a layer of graphene layer) between the second conductive line and the second insulator layer. In one example, the IC structure 400 includes a third interconnect layer (e.g., M1) between the first interconnect layer (e.g., M0) and the second interconnect layer (e.g., M2), where the third interconnect layer includes a third conductive interconnect, and where carbon is absent between the third conductive interconnect and the second conductive interconnect. Thus, graphene may be present in multiple interconnect layers, and the interconnect layers in which the graphene is present may not be consecutive (e.g., there may be an intervening interconnect layer without graphene). In other examples, additional or different interconnect layers 404 may include graphene. For example, one or more of M0, M1, M2, etc. may include graphene, and other ones of those interconnect layers may not include graphene.

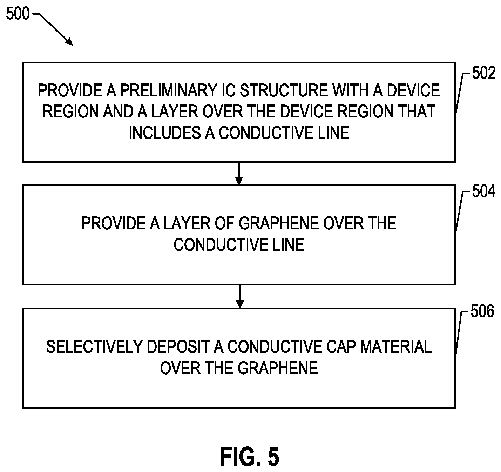

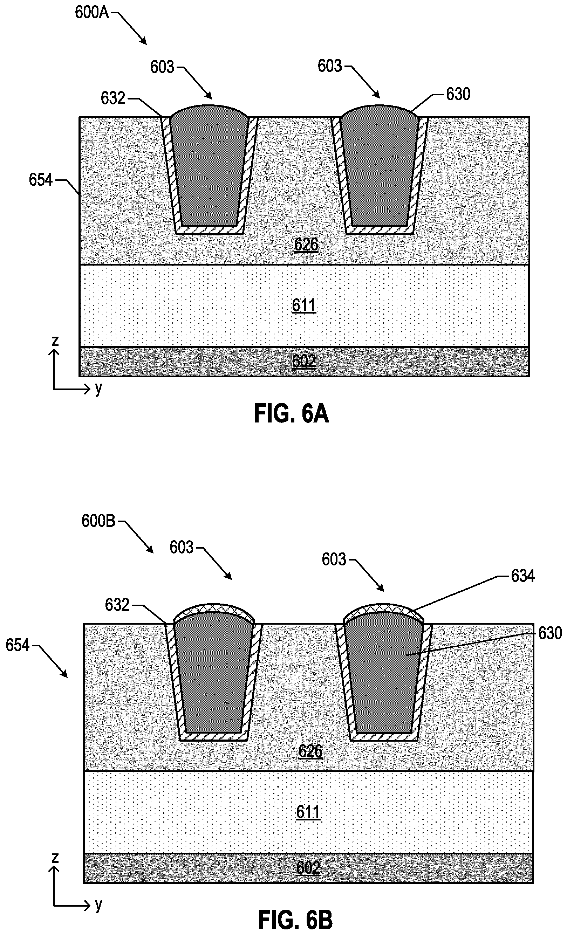

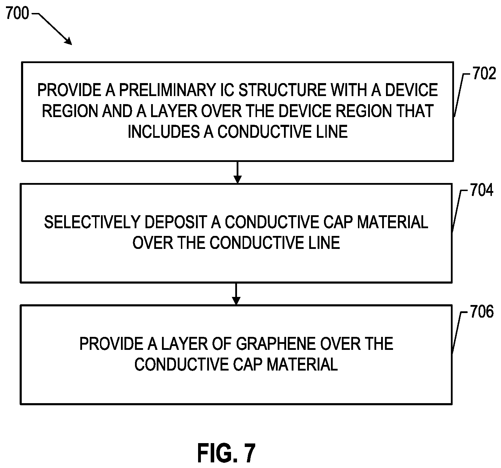

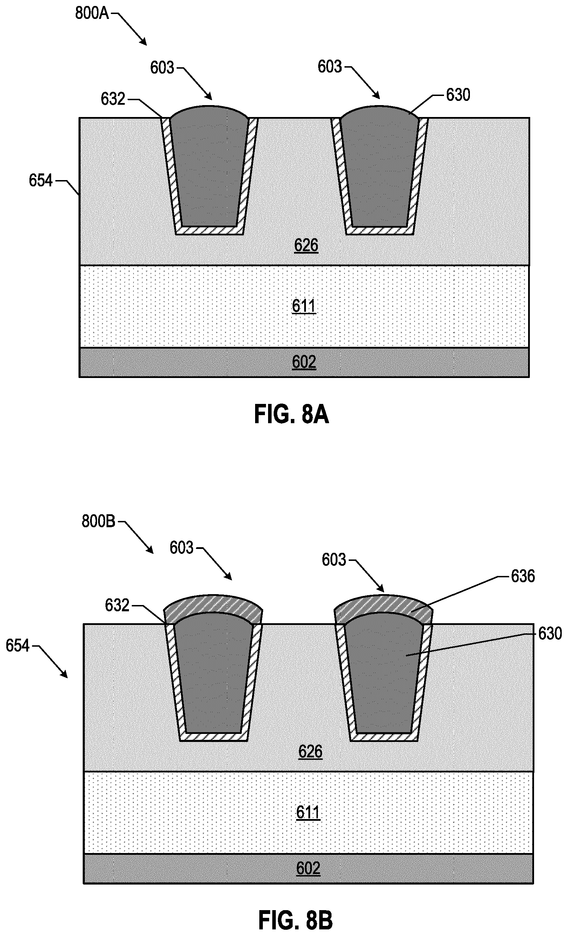

FIGS. 5 and 7 are flow diagrams of example methods for fabricating an IC structure with a conductive cap and graphene layer over a conductive line. FIG. 5 illustrates an example method 500 including selective cap deposition on graphene-capped conductive lines, in accordance with some embodiments. FIG. 7 illustrates an example method 700 for fabricating an IC structure including a layer of graphene over capped conductive lines. FIGS. 6A-6D provide cross-sectional side views at various stages in the fabrication of an example IC structure according to the method of FIG. 5, in accordance with some embodiments. FIGS. 8A-8D provide cross-sectional side views at various stages in the fabrication of an example IC structure according to the method of FIG. 7, in accordance with some embodiments. Although the operations of the method of FIGS. 5 and 7 are illustrated once each and in a particular order, the operations may be performed in any suitable order and repeated as desired. For example, one or more operations may be performed in parallel to fabricate multiple IC structures with conductive lines having a conductive cap and a layer of graphene substantially simultaneously. In another example, the operations may be performed in a different order to reflect the structure of an IC device in which conductive lines having a conductive cap and a layer of graphene will be implemented.

In addition, the example fabricating methods of FIGS. 5 and 7 may include other operations not specifically shown in FIGS. 5 and 7, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 4 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Turning to FIG. 5, the method 500 begins with a process 502 of providing a preliminary IC structure including a device region and a layer over the device region that includes a conductive line. The IC structure 600A of FIG. 6A is an example resulting structure of the process 502. The IC structure 600A includes a substrate 602 and a device region 611 over the substrate. The substrate 602 may be an example of the substrate 102 discussed above, and the device region 611 may be an example of the device region 111 discussed above. The IC structure includes an interconnect layer 654 over the device region. The interconnect layer may be an example of any interconnect/BEOL layer discussed herein that includes conductive lines 603 in an insulator material 626. The conductive lines 603 may be an example of conductive lines (e.g., metal lines or traces) discussed above. The conductive lines 603 include a conductive fill material 630, such as copper or another conductive material, and a liner 632. The liner 632 may be an example of the liner 232, and in one example, is or includes a barrier layer on sidewalls of trenches in which the conductive lines 603 are formed. In the example illustrated in FIG. 6A, a portion (e.g., a top portion or top surface) of the conductive material 630 of the conductive lines 603 is exposed.

The method 500 continues with the process 504 of providing a layer of graphene over the conductive line. The IC structure 600B of FIG. 6B illustrates an example result of the process 504. As can be seen in FIG. 6B, the IC structure 600B includes a layer of graphene 634 on the conductive material 630 of the conductive lines 603. In one example, providing the layer of graphene 634 involves depositing (e.g., growing) the graphene on the conductive material 630 (e.g., with a remote-plasma enhanced deposition process or any other suitable process for forming the layer of graphene 634). Unlike conventional techniques for depositing graphene, in one example, the method of depositing the layer of graphene 634 on the exposed portion of the conductive material 630 involves a relatively low temperature deposition process (e.g., around 400° C or lower, such as in a range of 250-400 ° C) in order to prevent damage to the existing devices and metal lines of the IC structure. In one example, the graphene 634 is selectively deposited only on the exposed conductive material 630 and not on the exposed surfaces of the insulator material 626. In one such example, a selective deposition technique also does not deposit the graphene 634 on the exposed portions of the liner 632 on the sidewalls of the openings in which the conductive lines 603 are formed. In one such example, the width of the layer of graphene 634 is about the same as a width of the conductive line 603, where the width is a dimension of the layer of graphene 634 and the conductive lines 603 in a plane substantially parallel to the substrate 602.

In one example, providing the layer of graphene 634 involves selectively depositing a monolayer of graphene on the exposed surface of the conductive material 630 of the conductive lines 603. Thus, in one example, the layer of graphene 634 may be a very thin (e.g., about 10 Angstrom) conformal layer of a material including carbon. In one example, the layer of graphene 634 over the conductive material 630 can reduce resistance in the conductive lines 603 (e.g., by reducing scattering at the surface of the conductive material 630). After depositing the layer of graphene 634, in one example, the method 500 may involve treating the exposed surface of the layer of graphene 634 with a plasma treatment. In one example, plasma treating the layer of graphene 634 may involve, for example, plasma treating the graphene with one or more of a hydrogen plasma, an oxygen plasma, or an ammonia plasma. In one such example, plasma treating the layer of graphene 634 may enable improved growth of a conductive cap material on the layer of graphene 634. However, excessive plasma treatment may damage or even remove the layer of graphene 634. In some examples, the method 500 does not involve plasma treating the layer of graphene 634.

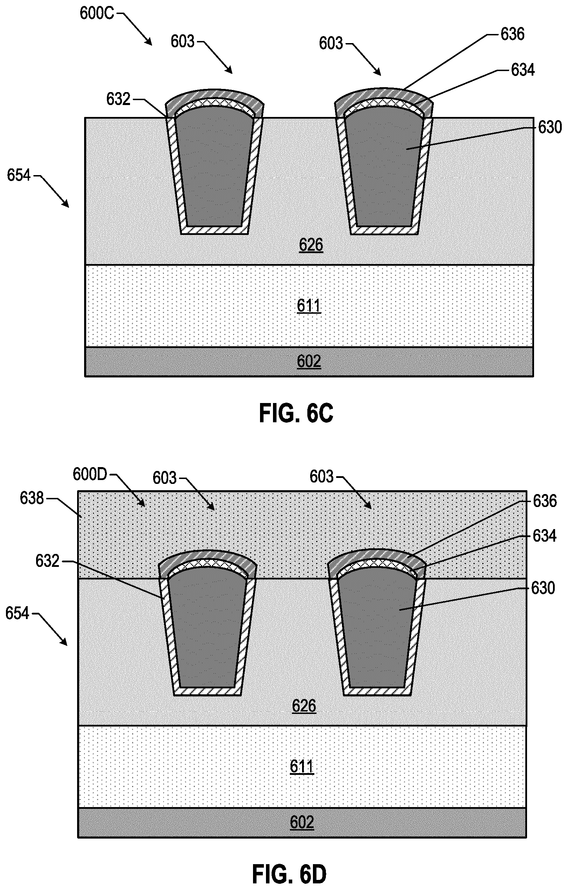

Referring again to FIG. 5, the method 500 continues with the process 506 of selectively depositing a conductive cap material over the graphene. The IC structure 600C of FIG. 6C illustrates an example result of the process 506. As can be seen in FIG. 6C, the IC structure 600C includes a layer of a conductive material 636 over the graphene 634. The conductive material 636 may be any suitable conductive material, such as those discussed above with respect to the conductive cap 236 of FIGS. 2A-2B. In the example illustrated in FIG. 6C, the conductive material 636 together with the liner 632 may encapsulate the conductive fill material 630 and limit electromigration into the surrounding materials. In one example, providing the conductive material 636 includes selectively depositing the second conductive material over the graphene and over the liner 632, but not over the insulator material 626. In one example, providing the layer of conductive material 636 may involve any suitable process for depositing the conductive material 636. In one example, depositing the conductive material 636 may involve a cyclical process of alternating depositing and treatment processes to grow a layer of the conductive material 636 to the desired thickness. In one such example, the resulting layer of conductive material 636 has a thickness in a range of 1.7-2 nanometers. One or more layers of material 638, such as an insulator material and/or etch stop material, may be provided over the capped graphene-capped conductive lines, such as depicted in FIG. 6D.

FIG. 7 is a flow diagram of another method 700 for fabricating an IC structure with a conductive cap and graphene layer over a conductive line. Unlike the method 500 of FIG. 5 in which a conductive cap is provided over a layer of graphene, the method 700 FIG. 7 involves providing a layer of graphene over a conductive cap. The method 700 begins with a process 702 of providing a preliminary IC structure including a device region and a layer over the device region that includes a conductive line. The IC structure 800A of FIG. 8A is an example structure resulting from the process 702. As can be seen in FIG. 8A, the preliminary IC structure 800A is the same as the preliminary IC structure 600A depicted in FIG. 6A. Thus, the IC structure 800A includes an interconnect layer 654 over a device region. The interconnect layer includes conductive lines 603 in openings in an insulator material 626, and a liner 632 on sidewalls of the openings in which the conductive lines 603 are formed. The method 700 continues with a process 704 of selectively depositing a conductive cap material over the conductive lines. The IC structure 800B of FIG. 8B is an example structure resulting from the process 704. In the example illustrated in FIG. 8B, the conductive cap material 636 is deposited directly on the conductive material 630 and on the exposed portions of the liner 632, but not on the insulator material 626. Any suitable process may be used to deposit the conductive material 636, such as the process 506 discussed above with respect to FIG. 5. In one such example, the surface of the conductive material 630 may first be cleaned (e.g., treated with a degas process) to enable deposition of the conductive cap material 636 on the conductive fill material 630.

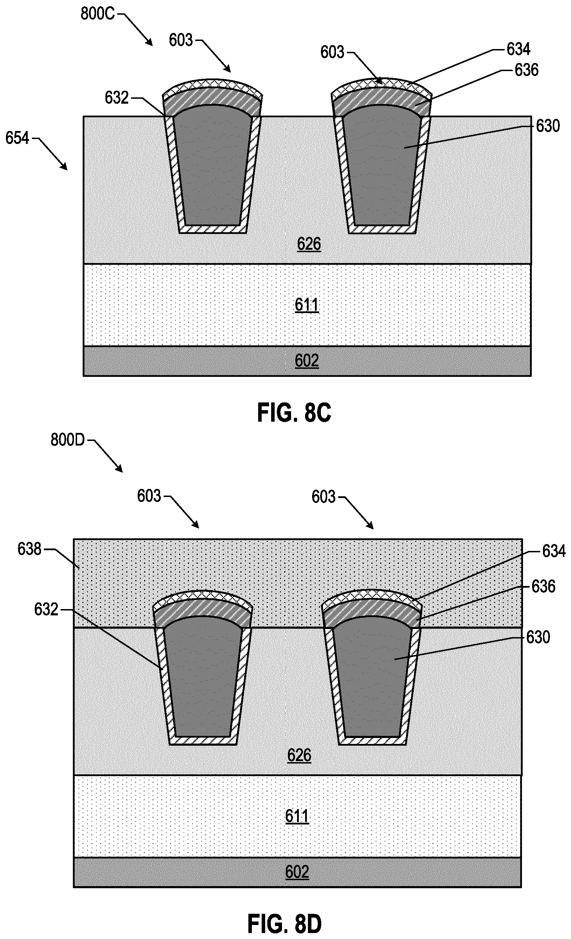

The method 700 continues with a process 706 of providing a layer of graphene over the conductive cap material. The IC structure 800C of FIG. 8C is an example structure resulting from the process 706. As can be seen in FIG. 8C, the IC structure 800C includes a layer of graphene 634 on the conductive cap material 636. In one example, the layer of graphene 634 is a monolayer of graphene on the conductive cap material 636. One or more layers of material 638, such as an insulator material and/or etch stop material, may be provided over the layer of graphene over the capped conductive lines, such as depicted in FIG. 8D.

Thus, FIGS. 5 and 7 illustrate two different methods 500 and 700 for fabricating conductive lines with a layer of graphene and a conductive cap over the conductive lines. One or more additional interconnect layers may be formed which may also include conductive lines capped with a layer of conductive material and a layer of graphene. Performing the methods 500 or 700 may result in several features in the final IC structures that are characteristic of the use of the methods 500 or 700. For example, one such feature is illustrated in an IC structure 600D shown in FIG. 6D in which a layer of graphene is present between the conductive fill material and the conductive cap material. In another example, one such feature is illustrated in an IC structure 800D shown in FIG. 8D in which a conductive cap is between the conductive fill material and a layer of graphene. In some examples, the layer of graphene together with the conductive cap material may be considered a multi-layer cap that includes graphene and a conductive material such as cobalt. An IC structure that includes an interconnect layer having a conductive cap and a layer of graphene over a conductive line may have improved performance due to the lower resistance that can be achieved with the layer of graphene over the conductive line.

IC devices/structures with conductive lines having a conductive cap and a layer of graphene as described herein (e.g., as described with reference to FIGS. 1-8D) may be used to implement any suitable components. For example, in various embodiments, IC devices described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

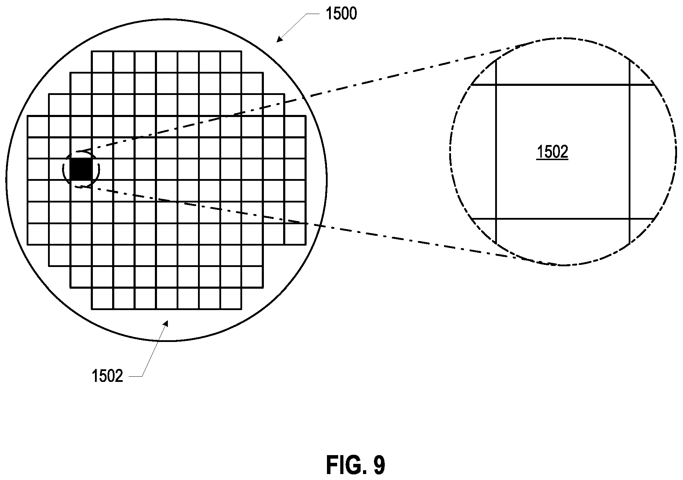

The IC devices/structures disclosed herein, e.g., the IC structures 100, 200, 300, or any variations thereof, may be included in any suitable electronic component. FIGS. 9-12 illustrate various examples of apparatuses that may include any of the IC devices disclosed herein.

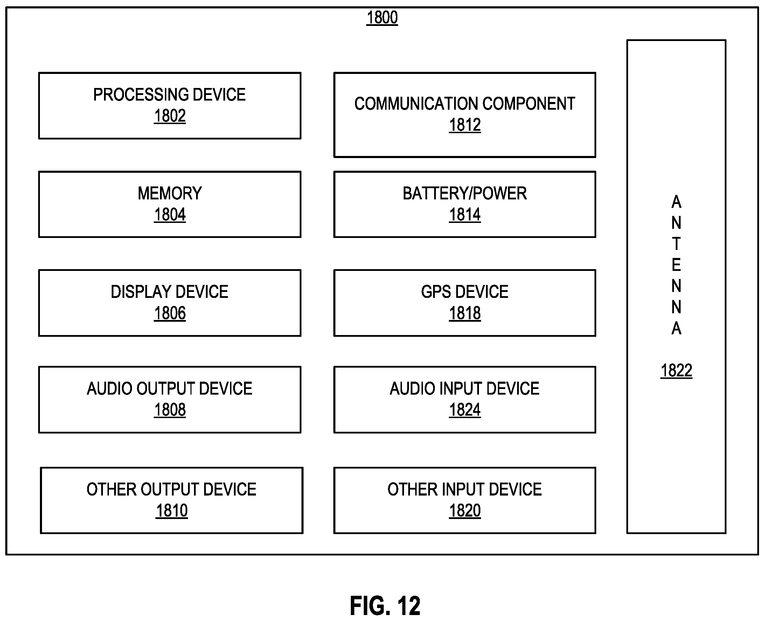

FIG. 9 is a top view of a wafer 1500 and dies 1502 that may include one or more IC structures in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures as described herein (e.g., any of the IC structures 100, 200, 300 described herein, or any combination of such IC structures), one or more transistors and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 12) or other logic that is configured to store information in the memory devices or execute instructions stored in the memory array.

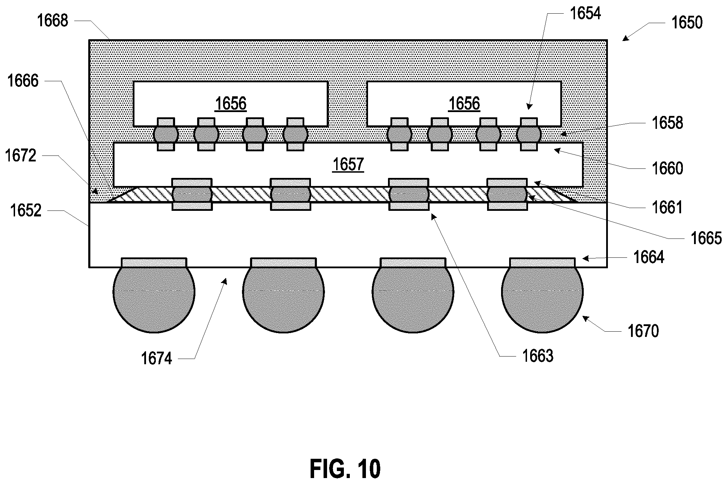

FIG. 10 is a side, cross-sectional view of an example IC package 1650 that may include one or more IC structures in accordance with any of the embodiments disclosed herein (e.g., any of the IC structures 100, 200, or 300, described herein, or any combination of such IC structures). In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 10 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 10 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

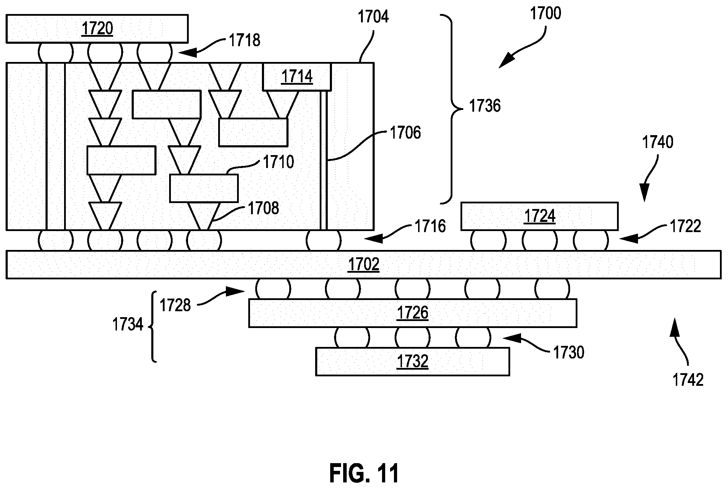

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 10 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 11.

The dies 1656 may take the form of any of the embodiments of the die 1502 discussed herein. In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 10 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 10, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 11 is a side, cross-sectional view of an IC device assembly 1700 that may include one or more IC packages or other electronic components (e.g., a die) including one or more IC devices in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 10 (e.g., may include one or more IC structures 100, 200, or 300, or any combination of such IC structures).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 11 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 11), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 11, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 9), an IC device (e.g., any of the IC structures 100, 200, or 300 described herein, or any combination of such IC structures), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 11, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 11 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 12 is a block diagram of an example electrical device 1800 that may include one or more IC structures 100 in accordance with any of the embodiments disclosed herein. For example, any suitable ones of the components of the electrical device 1800 may include one or more of the IC device assemblies 1700, IC packages 1650, or dies 1502 disclosed herein. A number of components are illustrated in FIG. 12 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 12, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a device region; and an interconnect layer over the device region, where the interconnect layer includes a conductive line including a first conductive material (e.g., copper or other suitable conductive material), a conductive layer (e.g., a conductive cap) over the conductive line, where the conductive layer includes a second conductive material (e.g., cobalt or another suitable conductive material), an insulator layer (e.g., an insulator material and/or etch stop material) over the conductive layer, and a layer (e.g., a graphene layer) between the conductive line and the insulator layer, where the layer includes carbon atoms arranged in a hexagonal lattice.

Example 2 provides the IC structure of example 1, where: the layer including the carbon atoms arranged in a hexagonal lattice includes a monolayer of graphene; and the monolayer of graphene is between the first conductive material and the second conductive material.

Example 3 provides the IC structure of example 1, where: the layer including the carbon atoms arranged in a hexagonal lattice includes a monolayer of graphene; and the second conductive material is between the first layer of conductive material and the monolayer of graphene.

Example 4 provides the IC structure of any one of examples 1-3, where: the interconnect layer is a first interconnect layer (e.g., M0), the conductive line is a first conductive line, the conductive layer is a first conductive layer, the insulator layer is a first insulator layer, and the layer is a first layer; the IC structure includes a second interconnect layer (e.g., M2) over the first interconnect layer; and the second interconnect layer includes a second conductive line including the first conductive material, a second conductive layer (e.g., a conductive cap) over the second conductive line, where the second conductive layer includes the second conductive material, a second insulator layer over the second conductive layer, and a second layer between the second conductive line and the second insulator layer, where the second layer includes carbon atoms arranged in a hexagonal lattice.

Example 5 provides the IC structure of example 4, where: the IC structure includes a third interconnect layer (e.g., M1) between the first interconnect layer and the second interconnect layer; the third interconnect layer includes a third conductive interconnect; and carbon is absent between the third conductive interconnect and the second conductive interconnect.

Example 6 provides the IC structure of any one of examples 1-5, where: the interconnect layer includes an insulator material; the conductive line is in an opening in an insulator material; the IC structure includes a liner on sidewalls of the opening; and the second conductive material is in contact with the liner.

Example 7 provides the IC structure of any one of examples 1-6, where: the layer including the carbon atoms arranged in a hexagonal lattice has a first thickness, where the first thickness is a dimension of the layer in a plane substantially orthogonal to the device region; the conductive layer has a second thickness, where the second thickness is a dimension of the conductive layer in the plane; and the second thickness is about 1.5 to 3 times greater than the first thickness.

Example 8 provides the IC structure of any one of examples 1-7, where: the layer has a thickness in a range of 8-12 Angstrom, where the thickness is a dimension of the layer in a plane substantially orthogonal to the device region.

Example 9 provides the IC structure of any one of examples 1-8, where: the first conductive material includes copper; the layer including the carbon atoms arranged in a hexagonal lattice includes a monolayer of graphene on the copper; and the conductive layer includes cobalt on the monolayer of graphene.

Example 10 provides the IC structure of any one of examples 1-9, where: the interconnect layer is a first interconnect layer and the conductive line includes a first conductive line; the IC structure includes a second interconnect layer over the first interconnect layer, where the second interconnect layer includes a second conductive line, and a conductive via between the first conductive line and the second conductive line; and the layer including the carbon atoms arranged in a hexagonal lattice is between the first conductive line and the conductive via.

Example 11 provides an IC structure, including a FEOL layer; a BEOL layer over the FEOL layer, where the BEOL layer includes an insulator material, a conductive line in an opening in the insulator material, where the conductive line includes a first conductive material, a liner on sidewalls of the opening, a material including carbon over the first conductive material, and a second conductive material over the material including carbon and over the liner.

Example 12 provides the IC structure of example 11, where: the material includes graphene.

Example 13 provides the IC structure of any one of examples 11-12, where: the material including carbon is absent between the liner on the sidewalls of the opening and the second conductive material.

Example 14 provides the IC structure of any one of examples 11-13, where: the second conductive material includes a conductive cap material having a first thickness; the material including carbon has a second thickness; and the first thickness is greater than the second thickness.

Example 15 provides an IC structure, including a device region; a metallization stack over the device region, where the metallization stack includes a plurality of layers, and where at least one of the plurality of layers includes a conductive line including a first conductive material, a multi-layer cap over the conductive line, where the multi-layer cap includes a layer of graphene over the first conductive material and a conductive layer over the layer of graphene, where the conductive layer includes a second conductive material, and an etch stop layer over the conductive layer.

Example 16 provides the IC structure of example 15, further including one or more liners on sidewalls of the conductive line, where: the layer of graphene is absent over the one or more liners.

Example 17 provides the IC structure of any one of examples 15-16, where: the layer of graphene has a first thickness, where the first thickness is a dimension of the layer in a plane substantially orthogonal to the device region; the conductive layer has a second thickness, where the second thickness is a dimension of the conductive layer in the plane; and the second thickness is about 1.5 to 3 times greater than the first thickness.

Example 18 provides the IC structure of any one of examples 15-17, where: the layer of graphene has a thickness in a range of 8-12 Angstrom, where the thickness is a dimension of the layer in a plane substantially orthogonal to the device region.

Example 19 provides an IC structure according to any one of examples 1-18, where the IC structure includes or is a part of a central processing unit.

Example 20 provides an IC structure according to any one of examples 1-19, where the IC structure includes or is a part of a memory device.

Example 21 provides an IC structure according to any one of examples 1-20, where the IC structure includes or is a part of a logic circuit.

Example 22 provides an IC structure according to any one of examples 1-21, where the IC structure includes or is a part of input/output circuitry.

Example 23 provides an IC structure according to any one of examples 1-22, where the IC structure includes or is a part of a field programmable gate array transceiver.

Example 24 provides an IC structure according to any one of examples 1-23, where the IC structure includes or is a part of a field programmable gate array logic.

Example 25 provides an IC structure according to any one of examples 1-24, where the IC structure includes or is a part of a power delivery circuitry.

Example 26 provides an IC package that includes an IC die including an IC structure according to any one of examples 1-25; and a further IC component, coupled to the IC die.

Example 27 provides an IC package according to example 26 where the further IC component includes a package substrate.

Example 28 provides an IC package according to example 26, where the further IC component includes an interposer.

Example 29 provides an IC package according to example 26, where the further IC component includes a further IC die.

Example 30 provides a computing device that includes a carrier substrate and an IC structure coupled to the carrier substrate, where the IC structure is an IC structure according to any one of examples 1-25, or the IC structure is included in the IC package according to any one of examples 26-29.

Example 31 provides a computing device according to example 30, where the computing device is a wearable or handheld computing device.

Example 32 provides a computing device according to examples 30 or 31, where the computing device further includes one or more communication chips.

Example 33 provides a computing device according to any one of examples 30-32, where the computing device further includes an antenna.

Example 34 provides a computing device according to any one of examples 30-33, where the carrier substrate is a motherboard.

Example 35 provides a method of fabricating an IC structure, the method including providing a preliminary IC structure including a device region and a layer over the device region that includes a conductive line in an opening in an insulator material, where the conductive line includes a first conductive material; providing a layer of graphene over the conductive line; and providing a second conductive material over the graphene.

Example 36 provides the method of example 35, further including prior to providing the second conductive material over the graphene, plasma treating the graphene with a hydrogen plasma, an oxygen plasma, or an ammonia plasma.

Example 37 provides the method of any one of examples 35-36, where: the first conductive material includes copper; and providing the layer of graphene includes depositing (e.g., growing) the graphene on the copper (e.g., with a remote-plasma enhanced deposition process).

Example 38 provides the method of any one of examples 35-17, where: providing the second conductive material includes selectively depositing the second conductive material over the graphene and not over the insulator material.

Example 39 provides the method of example 38, where: the preliminary IC structure includes a liner on sidewalls of the opening; and providing the second conductive material further includes depositing the second conductive material over the liner.

Example 40 provides the method of any one of examples 35-39, where: providing the layer of graphene includes providing a monolayer of graphene having a thickness in a range of 8-12 Angstrom; and providing the second conductive material includes providing a layer of the second conductive material having a thickness in a range of 1.7-2 nanometers.

Example 41 provides a method of fabricating an IC structure, the method including providing a preliminary IC structure including a device region and a layer over the device region that includes a conductive line in an opening in an insulator material, where the conductive line includes a first conductive material; providing a second conductive material over the first conductive material; and providing a layer of graphene over the second conductive material.

Example 42 provides a method according to any one of examples 35-41, where the IC structure is an IC structure according to any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a device region; and
an interconnect layer over the device region, wherein the interconnect layer includes:
a conductive line including a first conductive material,
a conductive layer over the conductive line, wherein the conductive layer includes a second conductive material,
an insulator layer over the conductive layer, and
a layer between the conductive line and the insulator layer, wherein the layer includes carbon atoms arranged in a hexagonal lattice.

2. The IC structure of claim 1, wherein:
the layer including the carbon atoms arranged in the hexagonal lattice includes a monolayer of graphene; and
the monolayer of graphene is between the first conductive material and the second conductive material.

3. The IC structure of claim 1, wherein:
the layer including the carbon atoms arranged in the hexagonal lattice includes a monolayer of graphene; and
the second conductive material is between the first conductive material and the monolayer of graphene.

4. The IC structure of any one of claims 1-3, wherein:
the interconnect layer is a first interconnect layer, the conductive line is a first conductive line, the conductive layer is a first conductive layer, the insulator layer is a first insulator layer, and the layer is a first layer;
the IC structure includes a second interconnect layer over the first interconnect layer; and
the second interconnect layer includes:
a second conductive line including the first conductive material, a second conductive layer over the second conductive line, wherein the second conductive layer includes the second conductive material, a second insulator layer over the second conductive layer, and a second layer between the second conductive line and the second insulator layer, wherein the second layer includes the carbon atoms arranged in the hexagonal lattice.

5. The IC structure of claim 4, wherein:
the IC structure includes a third interconnect layer between the first interconnect layer and the second interconnect layer;
the third interconnect layer includes a third conductive line; and
carbon is absent between the third conductive line and the second conductive line.

6. The IC structure of any one of claims 1-5, wherein:
the interconnect layer includes an insulator material;
the conductive line is in an opening in the insulator material;
the IC structure includes a liner on sidewalls of the opening; and
the second conductive material is in contact with the liner.

7. The IC structure of any one of claims 1-6, wherein:
the layer including the carbon atoms arranged in the hexagonal lattice has a first thickness, wherein the first thickness is a first dimension of the layer in a plane substantially orthogonal to the device region;
the conductive layer has a second thickness, wherein the second thickness is a second dimension of the conductive layer in the plane; and
the second thickness is about 1.5 to 3 times greater than the first thickness.

8. The IC structure of any one of claims 1-7, wherein:
the layer has a thickness in a range of 8-12 Angstrom, wherein the thickness is a dimension of the layer in a plane substantially orthogonal to the device region.

9. The IC structure of any one of claims 1-8, wherein:
the first conductive material includes copper;
the layer including the carbon atoms arranged in the hexagonal lattice includes a monolayer of graphene on the copper; and
the conductive layer includes cobalt on the monolayer of graphene.

10. The IC structure of any one of claims 1-9, wherein:
the interconnect layer is a first interconnect layer and the conductive line includes a first conductive line; and
the IC structure includes:
a second interconnect layer over the first interconnect layer, wherein the second interconnect layer includes a second conductive line, and a conductive via between the first conductive line and the second conductive line; and
the layer including the carbon atoms arranged in the hexagonal lattice is between the first conductive line and the conductive via.

11. A method of fabricating an integrated circuit (IC) structure, the method comprising:
providing a preliminary IC structure including a device region and a first layer over the device region that includes a conductive line in an opening in an insulator material, wherein the conductive line includes a first conductive material;
providing a second layer of graphene over the conductive line; and
providing a second conductive material over the graphene.

12. The method of claim 11, further comprising:
prior to providing the second conductive material over the second layer of graphene, plasma treating the second layer of graphene with a hydrogen plasma, an oxygen plasma, or an ammonia plasma.

13. The method of claims 11 or 12, wherein:
the first conductive material includes copper; and
providing the second layer of graphene includes depositing the graphene on the copper.

14. The method of any one of claims 11-13, wherein:
providing the second conductive material includes selectively depositing the second conductive material over the graphene and not over the insulator material.

15. The method of claim 14, wherein:
the preliminary IC structure includes a liner on sidewalls of the opening; and
providing the second conductive material further includes depositing the second conductive material over the liner.
